# DEMANDE DE BREVET EUROPEEN

(11) **EP 3 171 229 A1**
(43) Date de publication de la demande: **24.05.2017**
(21) Numéro de dépôt: 15195348.6
(22) Date de dépôt: 19.11.2015
(51) Int. Cl.: G04B 15/14, G04B 31/08, C25D 1/00, G03F 7/00, G04D 3/00

(54) **COMPOSANT D' HORLOGERIE**

(71) Demandeur: Nivarox-FAR S.A., 2400 Le Locle (CH)
(72) Inventeur: Charbon, Christian, 2054 Chézard-St-Martin (CH)
(74) Mandataire: Giraud, Eric

(57) **Abrégé**

Composant d'horlogerie, comportant un noyau en matériau électroformé, lequel noyau est au moins localement recouvert d'une couche d'or ou d'alliage d'or pour améliorer son comportement tribologique dans les zones comportant cette couche d'or ou d'alliage d'or, ce composant étant réalisé par un procédé de fabrication qui comporte les étapes consistant à :
- préparer une composition apte à une mise en oeuvre d'un composant massif par procédé « LIGA » ou électroformage;
- mettre en forme ce composant massif par procédé « LIGA » ou électroformage;
- recouvrir, au moins localement dans des zones sujettes à frottements, ce composant massif par une couche d'or ou d'alliage d'or.

## Description

### Domaine de l'invention

L'invention concerne un composant d'horlogerie.

L'invention concerne encore un procédé de fabrication d'un composant d'horlogerie.

L'invention concerne le domaine des mécanismes d'horlogerie, en particulier des mécanismes d'échappement.

### Arrière-plan de l'invention

La lubrification des mécanismes horlogers est toujours difficile à assurer, et à maintenir dans le temps. L'altération de la lubrification d'origine oblige en général les utilisateurs de montres à les renvoyer régulièrement en maintenance.

### Résumé de l'invention

L'invention se propose d'améliorer le comportement tribologique de certains composants de mécanismes d'horlogerie, en particulier de mécanismes d'échappement.

A cet effet, l'invention concerne un composant d'horlogerie selon la revendication 1.

L'invention concerne encore un procédé de fabrication d'un composant d'horlogerie selon la revendication 11.

### Description détaillée des modes de réalisation préférés

L'invention concerne un composant d'horlogerie, à tribologie améliorée.

Selon l'invention, ce composant comporte un noyau en matériau électroformé, lequel noyau est, au moins localement, recouvert d'une couche d'or ou d'alliage d'or, pour améliorer son comportement tribologique dans les zones comportant la couche d'or ou d'alliage d'or.

Plus particulièrement, le matériau électroformé comporte du nickel.

Plus particulièrement, le matériau électroformé comporte du cobalt.

Plus particulièrement, le matériau électroformé comporte du tungstène.

Plus particulièrement, le matériau électroformé comporte du NiP nickel-phosphore.

Plus particulièrement, le matériau électroformé comporte 8 à 15% en masse de NiP nickel-phosphore.

Plus particulièrement, le noyau est constitué d'un seul type de matériau.

Plus particulièrement, le noyau est le résultat d'une élaboration par un procédé « LIGA ».

Plus particulièrement, la couche d'or ou d'alliage d'or est un flash d'épaisseur inférieure ou égale à 1,0 micromètre.

Plus particulièrement, le composant est un composant de mécanisme d'échappement, parmi les composants usuels d'échappement : balancier, roue d'échappement, pignon d'échappement, ancre, ellipse.

L'invention concerne encore un procédé de fabrication d'un composant d'horlogerie, qui comporte les étapes consistant à :
- préparer une composition de matériau apte à une mise en oeuvre d'un composant massif par procédé « LIGA » ou électroformage;
- mettre en forme le composant massif par procédé « LIGA » ou électroformage;
- recouvrir, au moins localement dans des zones sujettes à frottements, le composant massif par une couche d'or ou d'alliage d'or.

Plus particulièrement, la couverture du composant massif par une couche d'or ou d'alliage d'or est effectuée sur la totalité de sa surface.

Plus particulièrement, la couverture du composant massif par une couche d'or ou d'alliage d'or est effectuée par technique galvanique ou/et par revêtement PVD.

Plus particulièrement, après la mise en forme du composant massif, et avant ou après la couverture du composant massif par une couche d'or ou d'alliage d'or, il est effectué une étape de traitement thermique de ce composant massif.

Plus particulièrement, la couverture du composant massif par une couche d'or ou d'alliage d'or est effectuée sous la forme d'un flash avec une épaisseur inférieure ou égale à 1,0 micromètre.

Plus particulièrement, le traitement thermique est effectué à une température comprise entre 200°C et 600°C pendant une durée de 1 à 6 heures.

Plus particulièrement, le traitement thermique est un traitement thermique de durcissement superficiel du composant massif.

Plus particulièrement, la composition est préparée avec une base de nickel.

Plus particulièrement, la composition est préparée avec 8 à 15% en masse de NiP nickel-phosphore.

Plus particulièrement, la composition comporte du cobalt ou/et du tungstène.

Plus particulièrement, la composition est préparée avec uniquement du NiP nickel-phosphore.

Plus particulièrement, le composant est un composant de mécanisme d'échappement, choisi parmi balancier, roue d'échappement, pignon d'échappement, ancre, ellipse.

## Revendications

1. Composant d'horlogerie, **caractérisé en ce qu'**il comporte un noyau en matériau électroformé, lequel noyau est, au moins localement, recouvert d'une couche d'or ou d'alliage d'or, pour améliorer son comportement tribologique dans les zones comportant ladite couche d'or ou d'alliage d'or.

2. Composant selon la revendication 1, **caractérisé en ce que** ledit matériau électroformé comporte du nickel.

3. Composant selon la revendication 1 ou 2, **caractérisé en ce que** ledit matériau électroformé comporte du cobalt.

4. Composant selon l'une des revendications 1 à 3, **caractérisé en ce que** ledit matériau électroformé comporte du tungstène.

5. Composant selon l'une des revendications 1 à 4, **caractérisé en ce que** ledit matériau électroformé comporte du NiP nickel-phosphore.

6. Composant selon la revendication 5, **caractérisé en ce que** ledit matériau électroformé comporte 8 à 15% en masse de NiP nickel-phosphore.

7. Composant selon l'une des revendications 1 à 5, **caractérisé en ce que** ledit noyau est constitué d'un seul type de matériau.

8. Composant selon l'une des revendications 1 à 7, **caractérisé en ce que** ledit noyau est le résultat d'une élaboration par un procédé « LIGA ».

9. Composant selon l'une des revendications 1 à 8, **caractérisé en ce que** ladite couche d'or ou d'alliage d'or est un flash d'épaisseur inférieure ou égale à 1,0 micromètre.

10. Composant selon l'une des revendications 1 à 9, **caractérisé en ce que** ledit composant est un composant de mécanisme d'échappement, parmi balancier, roue d'échappement, pignon d'échappement, ancre, ellipse.

11. Procédé de fabrication d'un composant d'horlogerie, **caractérisé en ce que** ledit procédé comporte les étapes consistant à :
- préparer une composition de matériau apte à une mise en oeuvre d'un composant massif par procédé « LIGA » ou électroformage;
- mettre en forme ledit composant massif par procédé « LIGA » ou électroformage;
- recouvrir, au moins localement dans des zones sujettes à frottements, ledit composant massif par une couche d'or ou d'alliage d'or.

12. Procédé selon la revendication 11, **caractérisé en ce que** la couverture dudit composant massif par une couche d'or ou d'alliage d'or est effectuée sur la totalité de sa surface.

13. Procédé selon la revendication 11 ou 12, **caractérisé en ce que** la couverture dudit composant massif par une couche d'or ou d'alliage d'or est effectuée par technique galvanique ou/et par revêtement PVD.

14. Procédé selon l'une des revendications 11 à 13, **caractérisé en ce que**, après ladite mise en forme dudit composant massif, et avant ou après la couverture dudit composant massif par une couche d'or ou d'alliage d'or, il est effectué une étape de traitement thermique dudit composant massif.

15. Procédé selon l'une des revendications 11 à 14, **caractérisé en ce que** la couverture dudit composant massif par une couche d'or ou d'alliage d'or est effectuée sous la forme d'un flash avec une épaisseur inférieure ou égale à 1,0 micromètre.

16. Procédé selon la revendication 14, **caractérisé en ce que** ledit traitement thermique est effectué à une température comprise entre 200°C et 600°C pendant une durée de 1 à 6 heures.

17. Procédé selon la revendication 14 ou 16, **caractérisé en ce que** ledit traitement thermique est un traitement thermique de durcissement superficiel dudit composant massif.

18. Procédé selon l'une des revendications 11 à 17, **caractérisé en ce que** ladite composition est préparée avec une base de nickel.

19. Procédé selon la revendication 18, **caractérisé en ce que** ladite composition est préparée avec 8 à 15% en masse de NiP nickel-phosphore.

20. Procédé selon la revendication 18 ou 19, **caractérisé en ce que** ladite composition comporte du cobalt ou/et du tungstène.

21. Procédé selon la revendication 18, **caractérisé en ce que** ladite composition est préparée avec uniquement du NiP nickel-phosphore.

22. Procédé selon l'une des revendications 11 à 21, **caractérisé en ce que** ledit composant est un composant de mécanisme d'échappement, choisi parmi balancier, roue d'échappement, pignon d'échappement, ancre, ellipse.
